# EUROPEAN PATENT SPECIFICATION

(11) **EP 1 357 772 B1**
(45) Date of publication and mention of the grant of the patent: **19.06.2013**
(21) Application number: 03252478.7
(22) Date of filing: 17.04.2003
(51) Int. Cl.: H05K 3/12, H01J 9/02

(54) **Manufacturing method for conductive layer wiring, electro-optic device, and electronic apparatus**
Herstellungsverfahren von Leitern aus einer leitfähigen Schicht, elektrooptische Vorrichtung, und elektronisches Gerät
Procédé de fabrication de câblage à couche conductrice, dispositif électro-optique, et appareil électronique

(30) Priority: 22.04.2002 JP 2002119448
(43) Date of publication of application: 29.10.2003
(73) Proprietor: Seiko Epson Corporation, Shinjuku-ku Tokyo 163-0811 (JP); ULVAC, INC., Chigasaki-shi, Kanagawa-ken (JP)
(72) Inventor: Furusawa, Masahiro, Suwa-shi, Nagano-ken (JP); Hirai, Toshimitsu, Suwa-shi, Nagano-ken (JP); Oda, Masaaki, Sanbu-gun, Chiba-ken (JP); Iwashige, Hisashi, Sanbu-gun, Chiba-ken (JP)
(74) Representative: Sturt, Clifford Mark

(56) References cited:
- EP-A- 0 930 641
- EP-A- 1 011 298
- WO-A-99/19900
- WO-A1-02/31068
- GB-A- 406 933
- US-A- 4 891 242
- US-B1- 6 214 259
- PATENT ABSTRACTS OF JAPAN vol. 2000, no. 09, 13 October 2000 (2000-10-13) & JP 2000 158639 A (CANON INC), 13 June 2000 (2000-06-13)

## Description

### BACKGROUND OF THE INVENTION

### Field of the Invention

The present invention relates to a technology for forming a conductive layer wiring on a base board. In particular, the present invention relates to a method for forming a conductive layer wiring having a predetermined pattern on the base board by disposing a liquid containing a metal particle on the base board by a liquid ejecting section.

### Description of Related Art

For a technique for forming a conductive layer wiring on a base board, a method in which a member layer for a conductive layer wiring is formed on a base board according to spin coating method or the like so as to form a predetermined pattern on the layer according photo-lithography method or the like is known.

In contrast, recently, a technique in which a liquid is disposed in a preferable position on a base board so as to form a pattern for a conductive layer wiring on a base board directly is proposed. In this technique, it is possible to omit or simplify processes which are concerning to the photo-lithography method.

For a technique for disposing a liquid in a predetermined position on a base board, there is a technique in which the liquid is ejected as a liquid drop from a nozzle which is disposed in a liquid ejecting section. According to this technique, a liquid is consumed more efficiently than in a case according to spin coat method; thus, there is an advantage in that it is possible to control an amount and position of the liquid which is disposed on a base board.

However, by a technique in which a liquid is disposed on a base board by a liquid ejecting section, it is difficult to make a conductive layer wiring in finer width. Although it is possible to make a conductive layer wiring in finer width by forming a surface of base board so as to be liquid-repellent, it may occur that the contact between the base board and the conductive layer wiring decrease in such a case.

EP 0930641 discloses a substrate manufacturing technique for forming patterns on substrates with the aid of an ink-jet system. The document also relates to a substrate manufacturing apparatus for forming arbitrary patterns on a substrate from a fluid. This apparatus comprises an ink-jet print head configured to allow the fluid to be ejected onto the substrate, treatment means for performing a specific treatment on the substrate and drive means configured to allow the relative positions of the ink-jet print head, the treatment means, and the substrate to be varied. Control means are disclosed for controlling the ejection of the fluid from the ink-jet print head, the treatment performed by the treatment means, and the drive effected by the drive means. The control means is configured to allow the treatment by the treatment means to be performed prior to the ejection of fluid from the ink-jet print head.

EP 0720202 discloses a display screen having a black matrix of a multilayer structure including a fine pigment particle layer containing fine pigment particles having an average diameter of 0.005 to 0.2 µm, and a black pigment layer containing black pigment particles having an average particle diameter of 0.2 to 5 µm.

WO 02/31068 A1 discloses an ink-jet ink with excellent ink properties which comprises a metal dispersion in which ultra-fine metal particles having a particle diameter of 100 nm or smaller are evenly dispersed independently. This ink is for use in printing or conductive-circuit formation with an ink-jet printer. The process comprises: a first step in which a metal vapor is contacted with the vapor of a first solvent by the gas vaporization method to obtain a dispersion of ultra-fine metal particles; a second step in which a second solvent which is a low-molecular polar solvent is added to the dispersion to sediment the ultra-fine metal particles and the first solvent is removed by extraction; and a third step in which a third solvent is added to the sediment to conduct solvent replacement and thereby obtain an ultra-fine-metal-particle dispersion. In the first and/or third step, a dispersant is added.

### SUMMARY OF THE INVENTION

The present invention was made in consideration of the above problem. An object of the present invention is to provide a method for forming a conductive layer wiring which can enhance a contact between the base board and the conductive layer wiring and realize a finer width in the conductive layer wiring.

Also, other object of the present invention is to provide a layered structure member which is provided with a conductive layer wiring which can enhance a contact between the base board and the conductive layer wiring and realize a finer width in the conductive layer wiring.

Also, other object of the present invention is to provide an electro-optic device and an electronic apparatus in which a wiring defect hardly occurs.

In order to realize the above objectives, in the present invention, a method for forming a conductive layer wiring as defined in claim 1 is provided.

In the above method for forming a conductive layer wiring, a first liquid which is used for forming a conductive layer wiring is disposed on a base board by a liquid ejecting section. Therefore, it is possible to simplify various processes and reduce the member to be consumed comparing to a case in which photo-lithography method is used. In addition, diffusion of the first liquid which is disposed on the base board is restricted by forming a surface of the base board so as to be liquid-repellent; thus, it is possible to realize a finer width in the conductive layer wiring. Also, in the above method for forming the conductive layer wiring, an interlayer made of a second liquid is formed on the base board which is formed as so to be liquid-repellent; therefore, a member which is contained in the second liquid improves the adhesion of the first metal particle and the base board. Thus, it is possible to enhance the contact between the base board and the conductive layer wiring.

In the above method for forming a conductive layer wiring, it is preferable that the interlayer is formed so as to have the same pattern as the predetermined pattern.

In this case, the first liquid is repelled at a surface of the base board which is outside of a pattern on the interlayer of which surface is formed as to be liquid-repellent; thus, it is possible to dispose the first liquid on the pattern on the interlayer reliably. By doing this, it is possible to dispose the first liquid so as to have a predetermined pattern.

Also, in the above method for forming a conductive layer wiring, it is preferable that at least a part of a dispersion medium in the second liquid which is disposed on the base board is removed before disposing the first liquid on the base board.

By removing at least a part of dispersion medium in the second liquid, it is possible to dispose the first liquid on the second liquid layer preferably. Here, it is sufficient if a part of the dispersion medium in the second liquid; thus, it is not necessary to remove entire part of the dispersion medium in the second liquid. It is not a problem if entire part of the dispersion medium in the second liquid is removed. Also, it is acceptable that a metal particle which is contained in the second liquid is sintered or oxidized after the dispersion medium is removed.

Also, it is preferable that a method for forming a conductive layer wiring according to the present invention further has a step for converting the first liquid and the second liquid which is disposed on the base board into layers in a single thermally processing step or an optically processing step.

By converting the first liquid and the second liquid which is disposed on the base board into layers in a single thermally processing step or an optically processing step, it is possible to improve production yield of the conductive layer wiring.

Also, in a method for forming a conductive layer wiring according to the present invention, it is preferable that the second liquid includes a second metal particle which is different from the first metal particle. For such second metal particles, a manganese member, a chromium member, a titanium member, a magnesium member, a silicon member, vanadium member, alloy made of these metals, and a metal particles which contain an oxide of these metal particles can be used. Furthermore, it is acceptable if the second liquid contains an organic metal compound of the above metals.

If the above metal particles are contained in the second liquid and if an interlayer is formed by such a liquid, an oxide of them may be formed easily. Such an oxide looks black commonly. For example, by disposing an interlayer which looks black in a preferable position in which a bus electrode which is disposed near a display electrode is visible, it is possible to realize a black matrix effect; thus, it is possible to improve a display contrast.

Furthermore, a transparent conductive layer is preferably formed on a surface of the base board. Here, the first liquid which contains, for example, a silver particle is used.

When a silver layer is formed on a transparent electrode layer, there is a possibility in that the transparent electrode layer and the silver layer react with each other and cause a color change. In such a case, it is possible to prevent such color change by disposing an interlayer which contains a metal member such as a manganese between the transparent electrode layer and the silver layer.

Also, an electro-optic device according to the present invention may be provided with a base board manufactured by the above method. For such an electro-optic device, for example, a liquid crystal display device, an organic electroluminescence display device, and a plasma display device can be named.

Also, an electronic apparatus according to the present invention may be provided with the electro-optic device which has the above aspects of the present invention. According to the present invention, the adhesion strength between the base board and the conductive layer wiring is high; thus, defect in the wiring hardly occurs.

Since the method for forming a conductive layer wiring comprises a surface processing step for forming a surface of the base board so as to be liquid-repellent and an interlayer forming step for forming an interlayer, it is possible to realize a finer width in the conductive layer wiring and improve the adhesion between the base board and the conductive layer wiring.

According to an electro-optic device of the present invention, defective wiring hardly occurs; thus, it is possible to realize higher product quality in the electro-optic device.

### BRIEF DESCRIPTION OF THE DRAWINGS

FIGS. 1A to 1C show a method for forming a wiring according to embodiments of the present invention graphically.
FIGS. 2A and 2B show an example for steps for forming an interlayer on a base board graphically.
FIG. 3 is a plan view showing a linear line as an example for an interlayer which is formed on the base board.
FIG. 4 is a plan view showing an intermittent line as an example for an interlayer which is formed on the base board.
FIGS. 5A to 5C show a process for disposing a liquid on the base board more specifically.
FIG. 6 is a perspective view for an electro-optic device according to the present invention which is used in a plasma display device.
FIG. 7 is a plan view for an example in which an electro-optic device according to the present invention is used in a liquid crystal display device.
FIG. 8 is a view showing an example in which an electronic apparatus according to the present invention is used in a mobile phone which is provided with a liquid crystal display device.
FIG. 9 is a view showing an example in which an electronic apparatus according to the present invention is used in a mobile phone information processing device which is provided with a liquid crystal display device.
FIG. 10 is a view showing an example in which an electronic apparatus according to the present invention is used in an electronic watch apparatus which is provided with a liquid crystal display device.

### DETAILED DESCRIPTION OF THE INVENTION

Next, a method for forming a conductive layer wiring on a base board is explained for an embodiment according to the present invention.

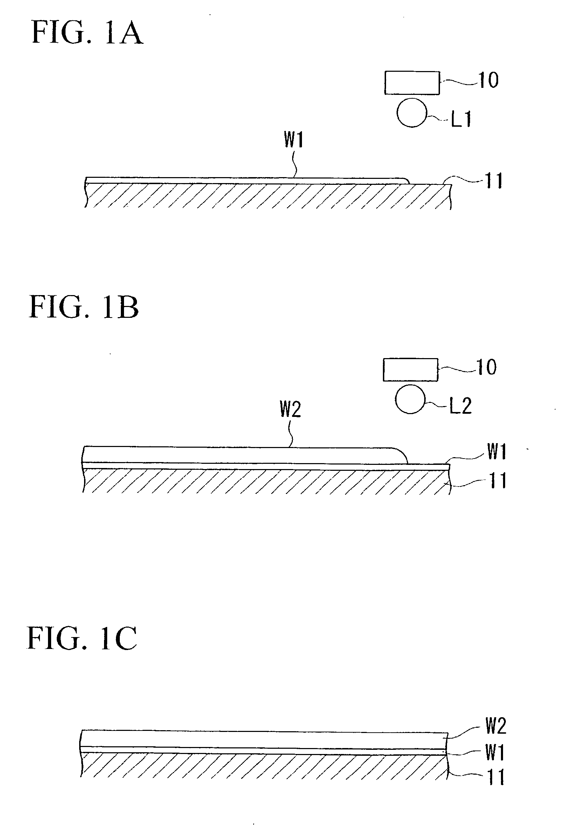

FIGS. 1A to 1C show a method for forming a wiring according to the present embodiment graphically. In this method for forming a wiring, a liquid is disposed on a base board and a conductive layer pattern which is supposed to be used for a wiring is formed on the base board. This method comprises a step for treating a surface of base board, a step for forming an interlayer (FIG. 1A), a step for forming a conductive wiring layer wiring (FIG. 1B), and step for performing a thermal process/optical process (FIG. 1C), etc..

Here, in the step for forming an interlayer, an interlayer which is disposed between the base board and a conductive layer wiring is formed. The interlayer improves the adhesion between the base board and the conductive layer wiring.

Also, in the steps for forming an interlayer and forming a conductive wiring layer, predetermined liquids are disposed on the base board. That is, in the step for forming a conductive wiring layer, a liquid (first liquid) which contains a first metal particle for forming a conductive layer wiring is used. Also, in the step for forming the interlayer, a liquid (second liquid) which is different from the above first liquid is used. When the liquid is disposed, an ink jet method in which a liquid is ejected as a liquid drop from a nozzle in a liquid ejecting head is used.

First, a liquid which is used in the steps for forming a conductive wiring layer and forming an interlayer is explained.

For the liquid which is used in a step for forming a conductive wiring layer, a dispersion liquid in which a metal particle is dispersed in a dispersion medium can be used. As such a conductive particle, a metal particle containing any one of gold, silver, copper, palladium, and nickel may be used. Also, a conductive polymer particle or a particle of a superconducting member can be used.

It is possible that a surface of these metal particle is coated with an organic member so as to enhance the dispersion.

It is preferable that the diameter of the conductive particle be 1 nm to 0.1 µm. If the diameter of the conductive particle is larger than 0.1 µm, the clogging may occur in a nozzle of the liquid drop ejecting head. Also, if the diameter of the conductive particle is smaller than 1 nm, the dispersion of the metal particle may be worsened. In addition, the volume ratio of the coating member to the metal particle becomes high. Thus, there will be a problem in that a ratio of the organic member in the obtained layer becomes excessive.

It is preferable that, in a liquid dispersion medium containing the metal particle, a vapor pressure in a room temperature be 0.001 mmHg to 200 mmHg (approximately 0.133 Pa to 26600 Pa). If the vapor pressure is higher than 200 mmHg, the dispersion medium evaporates rapidly after the ejection; thus, it is difficult to form a superior film layer.

Also, it is more preferable that the vapor pressure in the dispersion medium be 0.001 mmHg to 50 mmHg (approximately 0.133 Pa to 6650 Pa). If the vapor pressure is higher than 50 mmHg, clogging easily occurs in the nozzle when the liquid drop is ejected by ink jet method due to dryness; thus, it is difficult to perform a stable ejecting operation.

On the other hand, if the vapor pressure of the dispersion medium at room temperature is lower than 0.001 mmHg, the dispersion medium remains in the layer easily because it takes time for drying; thus, it is difficult to obtain a superior conductive film layer in a thermal process or an optical process.

There is no particular limitation for the dispersion medium as long as the dispersion medium can disperse the conductive particles and does not cause aggregations. More specifically, water; alcohols such as methanol, ethanol, propanol, and butanol; hydrocarbons such as n-heptane, n-octane, decane, toluene, xylene, cymene, durene, indene, dipentene, tetrahydronaphthalene, decahydronaphthalene, and cyclohexylbenzene; ethers such as ethylene glycol dimethyl ether, ethylene glycol diethyl ether, ethylene glycol methyl ethyl ether, diethylene glycol dimethyl ether, diethylene glycol diethyl ether, diethylene glycol methyl ethyl ether, 1,2-dimethoxyethane, bis(2-ethoxyethyl) ether, p-dioxane; and polar compounds such as propylene carbonate, γ-butyrolactone, N-methyl-2-pyrrolidone, dimethylformamide, dimethylsulfoxide, and cyclohexanone hydrocarbons, ethers can be listed. Among these dispersion media of water, alcohols, hydrocarbons, ethers are preferable in that the particles disperse easily, the dispersion liquid is stable, and these dispersion media can be used easily in the ink jet method. As further preferable dispersion media, it is possible to name water and hydrocarbons. These dispersion media can be used independently or in combination with other dispersion media as a mixture.

When the above conductive particles are dispersed in the dispersion medium, it is preferable that the dispersion density be 1 weight % to 80 weight %. By doing this, it is possible to adjust the dispersion density according to the thickness of the conductive layer. If the dispersion density is greater than 80 weight %, aggregation easily occurs; thus, it is difficult to form a uniform layer.

It is preferable that surface tension of the dispersion liquid in which the above conductive particle is dispersed be 0.02 N/m to 0.07 N/m. When the liquid is ejected by the ink jet method, if the surface tension is lower than 0.02 N/m, wettability of the ink composite on a nozzle surface increases; thus, a curved flying drops may curve easily. If the surface tension is greater than 0.07 N/m, the shape of a meniscus on the nozzle tip is unstable; thus, it is difficult to control the ejection amount and ejection timing.

In order to adjust the surface tension, it is possible to add a small amount of surface tension adjuster of the fluorine type, silicone type, nonionic type, or the like to the dispersion liquid as long as the contact angle with the base board does not decrease unreasonably. A nonionic surface tension adjuster improves the wettability of the liquid to the base board and leveling ability of the layer. A nonionic surface tension adjuster is useful for preventing microscopic roughness on the layer.

It is acceptable that the dispersion liquid contain an organic compound such as an alcohol, an ether, an ester, and a ketone according to necessity.

It is preferable that viscosity of the dispersion liquid be 1 mPa · s to 50 mPa · s. When the liquid drop is ejected by the ink jet method, when the viscosity is lower than 1 mPa · s, a periphery of the nozzle hole may be contaminated by the ink. If the viscosity is higher than 50 mPa · s, the nozzle hole is often clogged; thus it is difficult to eject the liquid drop smoothly.

On the other hand, for a liquid which is used in the step for forming an interlayer, a dispersion liquid in which a metal particle is dispersed in a dispersion medium is used in the present embodiment. Here, it is necessary that a preferable metal particle prove to have a function to improve the adhesion force between the first metal particle and the base board after the a thermal process/optical process which is explained later. Also, the particle may be conductive. It is acceptable that the particle may be non-conductive. For such a particle, a manganese member, a chromium member, a nickel member, a titanium member, a magnesium member, a silicon member, vanadium member, alloy made of these metals, and a metal particles which contain an oxide of these metal particles can be used. Furthermore, it is acceptable if the liquid contain an organic metal compound of the above metals.

It is preferable that the diameter of the metal particle be 1 nm to 0.1 µm. If the diameter of the metal particle is larger than 0.1 µm, there is a possibility in that the clogging in a nozzle of the above ink jet head occur.

For a dispersion medium of a liquid which contains the metal particle which is used in the step for forming an interlayer, a dispersion medium which is the same as that of the metal particle which is used in the step for forming a conductive layer can be used; therefore, an explanation is omitted. Also, an explanation for a dispersion medium in a case in which the particle is dispersed in the above dispersion medium is omitted. Also, explanations for a surface tension of the particle dispersion liquid and an additive are omitted because there is no substantial difference in the technical feature.

Next, above steps are explained in detail.

### Step for treating a surface

In a step for treating a surface, a surface of a base board which forms a conductive layer wiring is treated so as to be liquid-repellent to a liquid which is used in the steps for forming a conductive layer and forming an interlayer. More specifically, a surface is processed such that a contact angle made by the above liquid is between 30 degrees and 60 degrees.

For a base board, various member such as a Si wafer, a silica glass member, a glass member, a plastic film, and a metal board can be used.

For a method for controlling a liquid-repellent characteristics (wettability) on the surface, it is possible to employ, for example, a method in which a self-organizing layer is formed on a surface of the base board or a plasma processing method, etc..

In a self-organizing layer forming method, a self-organizing layer which is formed by an organic molecule layer or the like is formed on a surface of the base board.

An organic molecule layer which covers the surface of the base board is provided with a function group which can be bonded to the base board, a function group which can reform (control a surface energy) surface characteristics of the base board such as a lyophilic group or a liquid-repellent group formed opposite to the above function group, and a carbon chain in which a linear chain of carbons bonds these function groups or a part of the carbon chain is branching. Such an organic molecule layer which covers the surface of the base board forms a molecule layer such as a single molecule layer by bonding to the base board and self-organizing there.

Here, the self-organizing layer is formed by a bonding function group which can react with an atom which forms a bottom layer such as a base board and other linear chain molecule. The self-organizing layer is formed by orientating a component which has highly orientating characteristics due to a mutual reaction in the linear chain molecules. Such a self-organizing layer is formed by orientating a single molecule; therefore, it is possible to realize quite thin thickness of the layer. In addition, the layer is uniform with regard to a molecule point of view. That is, the same molecules are positioned on a surface of the base board; therefore, it is possible that a uniform and superior liquid-repellent characteristics and lyophilic characteristics can be add on a surface of the base board.

For a compound which has above high orientating characteristics, for example, a fluoroalkylsilanes can be used. By doing this, each compound is oriented such that a fluoroalkyl group is disposed on a surface of a layer; thus, a self-organizing layer is formed and uniform liquid-repellent characteristics is added on a surface of base board.

Examples of the compound which forms (which is capable of forming) a self-organizing layer include fluoroalkylsilanes (hereinafter referred to as "FAS") such as heptadecafluoro-1,1,2,2-tetrahydrodecyltriethoxysilane, heptadecafluoro-1,1,2,2-tetrahydrodecyltrimethoxysilane, heptadecafluoro-1,1,2,2-tetrahydrodecyltrichlorosilane, tridecafluoro-1,1,2,2-tetrahydrooctyltriethoxysilane, tridecafluoro-1,1,2,2-tetrahydrooctyltrimethoxysilane, tridecafluoro-1,1,2,2-tetrahydrooctyltrichlorosilane, and trifluoropropyltrimethoxysilane.

Here, one compound can be used. Also, it is possible that two or more compounds are combined. By using the FAS, it is possible to realize the close contact between the base board and the layer formed by the liquid and superior liquid-repellent characteristics.

The FAS is commonly represented by a structural formula such as RnSiX(₄₋ₙ). Here, n is an integer from 1 to 3. X represents a hydrolyzable group such as a methoxy group, an ethoxy group, and a halogen atom. R represents a fluoroalkyl group having a structure represented by (CF3)(CF2)x(CH2)y (here, x indicates an integer from 0 to 10. y indicates an integer from 0 to4). When more than two R or X are bonded to Si, it may be acceptable that all of Rs and Xs be the same. It may be acceptable that all of Rs and Xs be different. A hydrolyzable group which is indicated by X forms a silanol by hydrolysis and reacts with a hydroxyl group on a bottom layer such as a base board (glass member, silicon member) so as to be bonded with the base board in a siloxane bond form. On the other hand, R has a fluoro group such (CF₃) on its surface. Therefore, a surface of the bottom surface such as a base board is reformed to not to be wet (such that a surface energy is low).

Above members for forming the compound and a base board are enclosed in a closed container for two or three days in a room temperature. A self-organizing layer formed by an organic molecule layer is formed on the base board. Also, a self-organizing layer formed by an organic molecule layer is formed on the base board after three hours in a closed container under condition of temperature of 100°C. A method for forming a self-organizing layer in a gas phase has been described so far. However, it is possible to form a self-organizing layer in liquid phase. For example, a base board is dipped in a solution which contains a member for forming the self-organizing layer, and after that, a self-organizing layer is obtained by washing and drying the base board.

Here, it is preferable that a preparatory process be performed such as emitting a ultra-violet ray on a surface of the base board and washing the base board by a solution before forming a self-organizing layer.

In a plasma processing operation, a plasma is emitted to the base board under normal pressure condition or vacuum condition. Gases which can be used for the plasma processing operation can be selected from various gases according to requirement for a surface member of the base board on which the conductive layer wiring is produced. For such gases, tetrafluoromethane, perfluorohexane, and perfluorodecane can be listed.

Here, a surface of the base board can be formed to be liquid-repellent by attaching a film which has a preferable liquid-repellent characteristics such as a polyimide film treated with tetrafluoroethylene on the surface of the base board. Also, it is preferable that the above polyimide film be used for the base board. Also, when a surface of the base board has higher liquid-repellent characteristics than the preferable liquid-repellent characteristics, it is preferable that the condition of the surface of the base board be controlled by making a surface of the base board to be more lyophilic by emitting an ultra-violet ray having 170 to 400 nm wavelength or exposing the base board in an ozone atmosphere.

### Step for forming an Interlayer

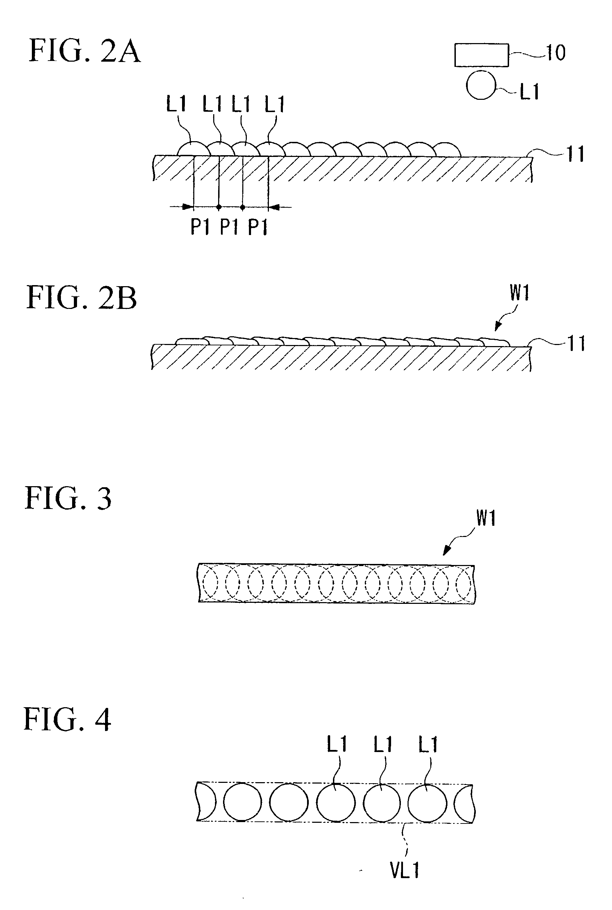

FIGS. 2A and 2B show an example for steps for forming an interlayer on a base board graphically. As explained above, this interlayer improves the adhesion between the base board and the conductive layer wiring.

Processes for forming in interlayer comprises a first step for disposing a liquid on a base board of which surface is formed to be liquid-repellent (FIG. 2A) and a second step for removing at least a part of medium (dispersion medium) which is contained in the liquid which is disposed on the base board (FIG. 2B).

In the first step, as shown in FIG. 2A, an ink jet head 10 moves relatively toward the base board 11 and a liquid for forming an interlayer is ejected as a liquid drop L1 from an ink jet head 10. The liquid drop L1 is disposed on the base board 11 by a constant distance (pitch P1). In the present embodiment, a disposition pitch P1 of the liquid drop L1 is smaller than a diameter of the liquid drop L1 immediately after the disposition on the base board 11. By doing this, the liquid drops L1 under condition immediately after the disposition on the base board 11 overlap each other; thus, a continuous line W1 can be formed. Here, the surface of the base board 11 is treated so as to have a contact angle of 30 degrees to 60 degrees with regard to the liquid. Therefore, if overlapping regions are too large, the continuous liquid moves in a line easily. Thus, a bulge is formed and lines in the rest of the region becomes thin; therefore, there is a possibility in that a line disconnection occurs. Therefore, it is necessary that the overlapping regions of the liquid drops be in a range of 1 to 10 % of the diameter of the liquid drop when the liquid drop is disposed on the base board 11.

Consequently, the liquid drops are disposed on an entire surface of the base board so as to form a layer having a predetermined pattern on the base board 11. Such a pattern on the layer is the same as the pattern of the wiring on the conductive layer wiring.

Here, similarly to a step for disposing the member which is explained later, it is acceptable that the disposition pitch of the liquid drops be larger than a diameter of the liquid drop under condition of immediately after the disposition on the base board. In such a case, a continuous line can be formed in drying steps which are performed in between the steps for disposing the member while shifting start position for ejecting the liquid and disposing the liquid drops in a repeated manner.

The condition for ejecting the liquid drops, in particular, such as the volume of the liquid drop and the pitch for disposing the liquid drop are determined such that the shape of a marginal region of a line which is formed on the base board 11 be in a preferable small gap shape. Here, a surface of the base board 11 is treated so as to be liquid-repellent; thus, it is possible to restrict a diffusion of the liquid drop which is disposed on the base board 11.

FIG. 3 is a plan view showing a linear line as an example for an interlayer which is formed on the base board. As explained above, by disposing liquid drops on the base board 11 in a repeated manner, it is possible to form a continuous line W1 on the base board 11.

Here, it is not necessary that an interlayer be a continuous line. For example, as shown in FIG. 4, it is acceptable that the liquid drops L1 are disposed so as to be apart from each other on a virtual line VL1 which forms a conductive layer wiring and an interlayers are formed in an intermittent manner.

Also, it is acceptable that the thickness of the interlayer be thinner than the thickness of a layer of the conductive layer wiring which is explained later.

In FIG. 2B, in the second step, a dispersion medium which is contained in the liquid which is disposed on the base board 11 is removed. In the present embodiment, it is acceptable that not all of the dispersion medium is removed but a part of the dispersion medium is removed. Also, it is acceptable that the interlayer is not completely dried. Even if the interlayer is dried, particles are only layered but not sintered; therefore, the layered particles are re-dissolved to some extent because of the dispersion medium contained in the liquid which is supposed to be a conductive layer wiring which is disposed thereon. Thus, it is possible to anticipate the same effect as an effect in a case in which the particles are completely removed only by removing a part of the dispersion medium. Also, an object of such a partial removal of the particles is to shorten a time necessary for drying operation.

The dispersion medium can be removed only by leaving the base board 11 under a room temperature condition. The dispersion medium can be removed also by using a heating section. For example, a heating section such as a hot plate, an electric furnace, a hot wind generator can be used. In addition to such ordinary heating sections, it is possible to perform a lamp-annealing operation. Here, in such a case, it is acceptable that a heating operation or a light emitting operation be intensified until all the dispersion medium which is contained in the liquid drop is removed so as to be converted into a dried layer. Conversion from the liquid into a dry layer can be operated in one time in the heat processing/optical processing step after completing disposing all the liquid; therefore, it is sufficient if the dispersion medium are removed to some extent. For example, it is sufficient if the base board is left under a room temperature such as 25°C for several minutes. It is also acceptable that the interlayer is converted into a dry layer in the heating process/optical process (for example, in a heating process under condition of nearly 300°C) after a step for forming the interlayer.

Such operations can be performed simultaneously with the ejection of the liquid. For example, it is possible to expedite the drying operation of the liquid drop immediately after the liquid drop is disposed on the base board by heating the base board in advance or by cooling the in jet head while using a dispersion medium having lower boiling point.

### Step for disposing the member for forming the conductive layer wiring

Next, in a step for disposing the member for forming the conductive layer wiring, as shown in FIG. 1B, a liquid which forms the above conductive layer wiring is made a liquid drop L2 and the liquid drop L2 is disposed on a layer W1 for an interlayer which is formed on the base board 11 from the liquid ejecting head 10.

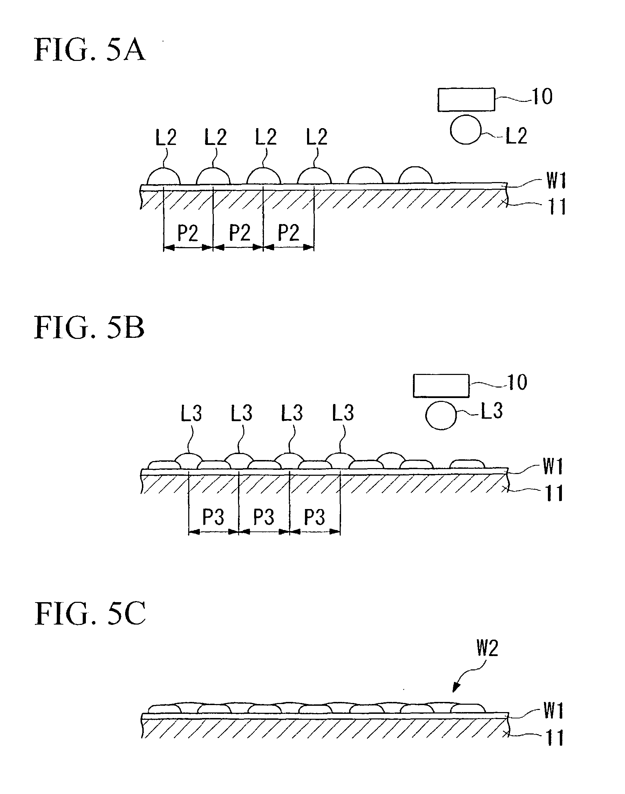

Here, FIGS. 5A to 5C show a process for disposing a liquid on the base board more specifically.

First, as shown in FIG. 5A, the liquid drops L2 which are ejected from the liquid ejecting head 10 are disposed on a layer W1 of the interlayer consecutively with a constant interval. In the present embodiment, a disposition pitch for the liquid drop L2 is predetermined so as to be larger than a diameter of the liquid drop L2 under condition of immediately after the disposition on the base board 11. Also, the disposition pitch P2 of the liquid drop L2 is predetermined so as to be twice as large as the diameter of the liquid drop L2 or smaller under condition of immediately after the disposition on the base board 11.

Next, as shown in FIG. 5B, the above operation for ejecting the liquid drop is repeated. That is, as similarly to a case shown in FIG. 5A, the liquid is converted to a liquid drop L3 and the liquid drop L3 is ejected on the base board 11 from the liquid ejecting head 10 so as to have a constant interval.

In such a case, the volume (amount of liquid in one liquid drop) of the liquid drop L3 and the disposition pitch P3 are the same as the volume of the liquid drop L2 and the disposition pitch P2. Also, the disposition of the liquid drop L3 is shifted from the disposition of liquid drop L2 by half a pitch and the liquid drop L3 is disposed in a middle of the liquid drops L2 which are disposed on the base board 11.

As explained above, the disposition pitch P2 of the liquid drop L2 on the base board 11 is larger than a diameter of the liquid drop L2 under condition of immediately after the disposition on the base board. Also, the disposition pitch P2 of the liquid drop L2 on the base board 11 is twice as large as a diameter of the liquid drop L2 or smaller under condition of immediately after the disposition on the base board. Therefore, the liquid drop L3 is disposed in the middle of the liquid drops L2; thus, a part of the liquid drop L3 overlaps the liquid drop L2 and an interval between the liquid drops L2 is filled. By doing this, as shown in FIG. 5C, a continuous line W2 which is formed by a liquid which is supposed to be a conductive layer wiring is formed on the layer W of the interlayer. In addition, the liquid drops are disposed on the entire surface of the base board; therefore, a layer which is used for a wiring having a predetermined pattern is formed on the base board 11.

In such a case, as explained above, a surface of the base board 11 is formed so as to be liquid-repellent; the liquid is repelled at an outside surface of the layer W1 of the interlayer; thus, it is possible to dispose the liquid on the layer W1 of the interlayer reliably. Also, as explained above, the layer W1 of the interlayer is re-dissolved to some extent in the dispersion medium contained in a liquid which forms the conductive layer wiring; therefore, the layer W1 of the interlayer indicates relatively high quite lyophilic characteristics with the above liquid. Therefore, the liquid which is disposed on the layer W1 of the interlayer can diffuse on the layer W1 of the interlayer. Furthermore, as explained above, the layer W1 of the interlayer is formed in the same pattern as the wiring pattern in the conductive layer wiring; thus, the liquid which diffuses on the layer W1 of the interlayer can be disposed reliably on a preferable wiring pattern.

Here, it is acceptable that a drying operation is performed according to necessity in order to remove a part of the dispersion medium after the liquid drop is disposed on the base board 11. Such a drying operation is performed, for example, each time of the consecutive disposition operation for the liquid drop. An object, a method, and devices for the drying process are the same as those in the second step in the process for forming the interlayer; therefore, the explanation is omitted.

Also, by increasing the repetition times for the above disposition operation of the liquid drops, the liquid drops are layered successively; thus, the thickness of the layer W2 which is supposed to form a conductive layer wiring increases. Such a thickness is determined according to a preferable thickness necessary for a conductive layer wiring as a final product. The repetition times for disposing the liquid drops are determined according to the above thickness.

Here, it is possible to change the disposition pitch of the liquid drop and shift amount in repeating the liquid drop disposition preferably. For example, as shown in FIGS. 2A and 2B, it is acceptable that the liquid drops are ejected such that the a part of the liquid drops under condition of immediately after the ejection may overlap each other.

### Thermal Processing/Optical Processing

In the thermal processing/optical processing, a dispersion medium which is contained in the liquid drop which is disposed on the base board or a coating agent are removed completely. Also, in the thermal processing/optical processing, the metal particles contacts each other and are sintered to be bonded so as to decrease an electric resistance. Here, in the present embodiment, a heating processing of the liquid for the interlayer and a heating processing for the liquid for a conductive layer wiring are performed simultaneously.

A heating processing or an optical processing is commonly performed in an atmosphere. It is possible to perform the heating processing or the optical processing in an inert gas atmosphere such as a nitrogen, argon, or helium according to necessity. A temperature for the heating processing and/or the optical processing is determined preferably according to factors such as a boiling point (vapor pressure) of the dispersion medium, kinds of an atmospheric gas and its pressure, thermal behavior of the particle such as dispersion and oxidization, coating agent and its amount, and heat resistance of the base member.

For example, it is necessary to perform a baking operation under condition of 200°C or higher in order to remove the coating agent made of an organic matter.

Also, it is preferable that the baking operation is performed under condition of 100°C or lower when a base board made of a plastic member is used.

The heating processing and/or the optical processing can be performed by other methods in which a hot plate, or an electronic furnace is used. Also, The heating processing and/or the optical processing can be performed by a lamp-annealing method.

A light source for a light which is used in the lamp-annealing method is not limited specifically. For a light source for a light which is used in the lamp-annealing method, a light sources such as an infrared ray lamp, a xenon lamp, a YAG laser (yttrium aluminum garnet laser), an argon laser, a carbon dioxide laser, an excimer laser of XeF, XeCl, XeBr, KrF, KrCl, ArF, and ArCl can be used. Commonly, these light source has an output in an range of 10W to 5000W. However, in the present embodiment, it is sufficient if the output of the light source is in a range of 100W to 1000W.

By the above heating process and/or the optical processing, an electric contact between the conductive particles which are contained in the liquid is obtained; thus, the layer W2 which is supposed to be a conductive layer wiring is converted into a conductive layer wiring.

Also, the layer W1 which is supposed to be the interlayer enhances the bonding characteristics between the conductive particle which is supposed to be a conductive layer wiring and the base board 11 by a function of the particle which is contained in the liquid.

In the case of a conductive layer wiring which is formed according to the present embodiment, it is possible to form the conductive layer wiring in approximately the same width as the diameter of a dispersion liquid under condition of immediately after the disposition on the base board. Also, the bonding characteristics between the metal particle which is contained in the conductive layer wiring and the base board improves because of the metal particle which is contained in the interlayer; thus, the adhesion between the base board and the conductive layer wiring increases.

Therefore, according to the present embodiment, it is possible to realize a finer width in the conductive layer wiring and enhance the adhesion between the base board and the conductive layer wiring.

### Embodiment 1

Here, an embodiment in which a conductive layer wiring is formed on a glass base board is explained according to the above embodiment for a method for forming a conductive layer wiring.

A glass base board is cleaned and an ultra-violet ray having wavelength of 254 nm with intensity of 10 mW/cm² is emitted to the glass base board for ten minutes. By doing this, a surface of the base board becomes lyophilic. The glass base board and 1 gram of heptadecafluoro-1,1,2,2-tetrahydrodecyltriethoxysilane are contained in a closed container having volume of 50 litter so as to be kept for two hours under condition of 120°C. By doing this, a single molecular layer having a fluoroalkyl group on an entire surface of the base board is formed. A contact angle made between the surface of the base board and the liquid in which the metal particle which is explained later is dispersed is 70 degrees in both liquids for the interlayer and the liquid for the wiring. Furthermore, an ultra-violet ray having the same characteristics as that in the above ultra-violet ray is emitted for two minutes; thus, the contacting angle between the surface of the base board and the liquid is 30 degrees.

For a liquid which is supposed to be a conductive layer wiring, a liquid made by substituting a dispersion medium of a liquid (commodity name "Perfect Silver" produced by Vacuum Metallurgical Co., Ltd.) in which an ultra-fine silver particle having approximately 5 nm of diameter is dispersed in an organic solution by a tetradecane such that the density is 60 wt%, the viscosity is 8 mPa · s is used. Also, for a liquid for the interlayer, a liquid in which an ultra-fine manganese particle having approximately 5 nm of diameter is dispersed in a tetradecane is used. The density of the manganese dispersion liquid is 4 wt%. The viscosity of the manganese dispersion liquid is 4 mPa · s. These liquids are ejected on the base board in a predetermined pattern by an ink jet printer head (made by modifying a similar head of a printer head in a printer: Model PM950C) produced by SEIKO EPSON CORPORATION.

First, a manganese dispersion liquid is ejected on a surface of the base board having 30 degrees of contacting angle according to a predetermined pattern. The liquid drop has approximately 5 pico-litter in size. The diameter of the liquid drop is 20 µm. This liquid drop diffuses approximately over 40 µm on the base board after disposed. The liquid drops are ejected at intervals of 38 µm so as to form a line pattern (such that 2 µm, that is 5% of the diameter of the liquid drop, of marginal region in the liquid drop overlaps a neighboring liquid drop). The liquid drop does not diffuse on a surface of the base board because the surface of the base board is formed so as to be liquid-repellent; thus, a line having an accurate edge shape is formed.

Furthermore, the base board is kept under condition of 25°C temperature condition for two minutes so as to remove a part of the dispersion medium. After that, a silver dispersion liquid is ejected in the same pattern as the ejection patter in a case of the manganese dispersion liquid in a similar manner. In such a case, the size of the liquid drop is 5 pico-litter. Such a liquid drop is ejected on a manganese pattern at intervals of 40 µm. As a result, the liquid drop spreads in the same shape as that in a case of the manganese pattern and does not diffuse over thereoutside. After that, a hot air having 100°C of temperature is blown on entire surface of the base board for 15 seconds. The silver dispersion liquid is ejected again with 40 µm pitch. Furthermore, the hot air drying operation and ejection with 40 µm pitch are repeated similarly.

Finally, the entire base board is baked in an atmosphere having 300°C of temperature for 30 minutes; thus, a conductive layer wiring pattern having 3 µm of thickness, 40 µm of line width, and 2µ Ω cm of specific resistance ratio is formed. In order to test the adhesion strength of the conductive layer wiring, a tape-removal test is performed. The result is preferable in that the conductive layer wiring is not removed at all. For a comparison example, a wiring pattern having no interlayer is formed by approximately the same method as the above method and a tape-removal test is performed. The adhesion strength is higher for the conductive layer wiring having the interlayer than the conductive layer wiring without the interlayer.

### Embodiment 2

When a conductive layer wiring is produced in a similar processes to the Embodiment 1 by changing the manganese particle in the Embodiment 1 into one of these among chromium particle, a nickel particle, a titanium particle, a magnesium particle, a silicon particle, and a vanadium particle, it is possible to realize an effect of improving adhesion similarly to a case of the Embodiment 1.

Next, a plasma display device is explained for an example of electro-optic device according to the present invention.

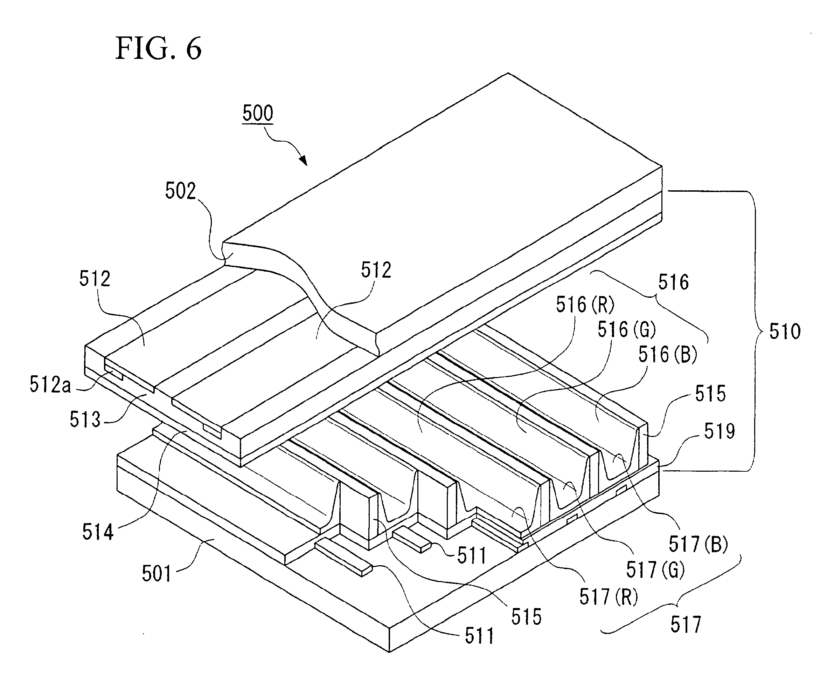

FIG. 6 is a perspective view for an plasma display device 500 according to the present invention. The plasma display device 500 comprises glass base boards 501, 502, and an electricity discharging display section 510 which is formed between the glass base boards 501, 502.

An address electrode 511 is formed on a surface of the glass base board in a stripe manner with a predetermined interval. A dielectric layer 519 is formed so as to cover the address electrode 511 and a surface of the glass base board 501. A rib 515 is formed on the dielectric layer 519 so as to be formed between the address electrode 511, 511 along the address electrode 511. A fluorescent member 517 is placed inside of the stripe area which is separated by the rib 515. The fluorescent member 517 emits any one of fluorescent light such as red, green, or blue. A red fluorescent member 517 (R) is placed on a bottom and a side surface of a red discharging chamber 516 (R). A green fluorescent member 517 (G) is placed on a bottom and a side surface of a green discharging chamber 516 (G). A blue fluorescent member 517 (B) is formed on a bottom and a side surface of a blue discharging chamber 516 (B).

On the other hand, a display electrode 512 which is formed by transparent conductive layers in a direction orthogonal to the address electrode 511 is formed on the glass base board 502 in a stripe manner with a predetermined interval. A bus electrode 512a is formed on the display electrode 512 so as to compensate the display electrode 512 which has a high electric resistance. Also, a dielectric layer 513 is formed so as to cover these members. Furthermore, a protecting layer 514 which is formed by a MgO or the like is formed.

The glass base board 501 and the glass base board 502 are attached so as to face each other such that the address electrodes 511··· and the display electrodes 512 ··· are orthogonal each other.

An electricity discharging display section 510 is formed by number of electricity discharging chambers 516. In number of electricity discharging chambers 516, a pixel is formed by a region in which the red discharging chamber 516 (R), the green discharging chamber (G), and the blue discharging chamber (B) are combined and an area which is surrounded by a pair of display electrodes.

The address electrode 511 and the display electrode 512 are connected to an alternative current power supply which is not shown in the drawing. By flowing the electricity to each electrode, a fluorescent member 517 is excited to illuminate in the electricity discharging display section 510; thus, it is possible to perform a color display operation.

In the present embodiment, the bus electrode 512a and the address electrode 511 are formed according to the above method for forming the conductive layer wiring shown in FIGS. 1A and 1B. Therefore, the adhesion of the bus electrode 512a and the address electrode 511 on the base board is strong; thus, there the defect wiring hardly occurs.

Here, when the interlayer is formed by a manganese compound (manganese oxide), a necessary conductivity between the display electrode 512 and the bus electrode 512a can be realized by making the manganese layer into a very thin porous layer even though the manganese oxide is a non-conductive member. Also, in such a case, the interlayer looks black; thus, the interlayer works like a black matrix; thus, it is possible to improve a contrast in a display.

Next, a liquid crystal display device is explained for other example of the electro-optic device according to the present invention.

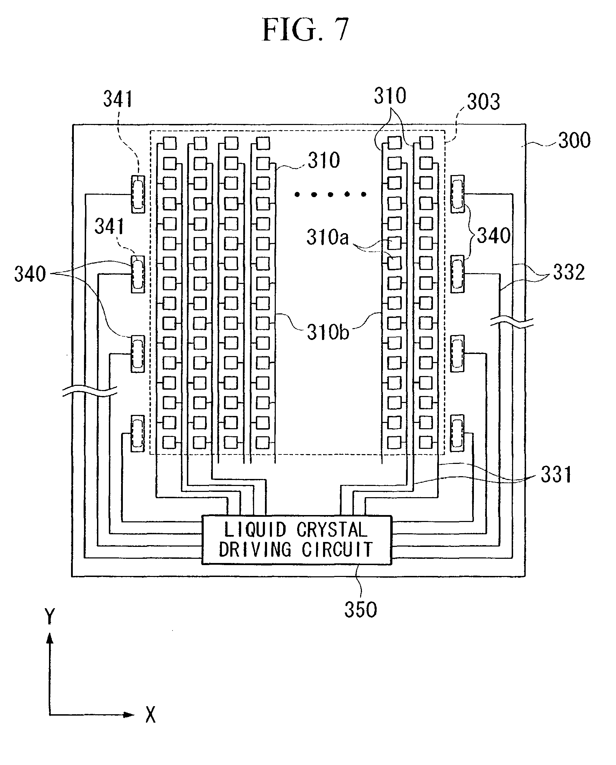

FIG. 7 is a plan layout of a signal electrode, etc., on a first base board in a liquid crystal display device according to the present embodiment. The liquid crystal display device according to the present embodiment approximately comprises the first base board, a second base board (not shown in the drawing) in which a scanning electrode is formed, and a liquid crystal (not shown in the drawing) which is sealed between the first base board and the second base board.

As shown in FIG. 7, a number of signal electrodes 310··· are formed in a pixel region 303 on the first base board 300 in a multi-matrix form. In particular, each signal electrode 310··· is formed by a number of pixel electrode part 310a which are placed so as to correspond to each pixel and a signal wiring part 310b which connects the pixel electrode parts 310a··· in a multi-matrix form. Each signal electrode 310 expands in a Y direction.

Also, reference numeral 350 indicates a liquid crystal driving circuit having one-tip structure. The liquid crystal driving circuit 350 and an end (shown in a bottom region in the drawing) in the signal wiring part 310b··· are connected via a first lead-in wiring 331···.

Also, reference numeral 340··· indicates vertical conductive terminals. The vertical conductive terminals 340··· and a terminal which is placed on the second base board which is not shown in the drawing are connected by a vertical conductive members 341···. Also, the vertical conductive terminals 340··· and a liquid crystal driving circuit 350 are connected via a second lead-in wiring 332.

In the present embodiment, the signal wiring parts 310b···, the first lead-in wirings 331···, and the second lead-in wirings 332··· which are formed on the first base board 300 are formed according to a method for forming the conductive layer wiring shown in FIGS. 1A and 1B. Also, when a large size base board for a liquid crystal is produced, it is possible to use the wiring members efficiently; thus, it is possible to reduce the product cost. It is possible to apply the present invention to devices such as a base board for a circuit in which a conductive layer wiring is formed and a semiconductor wiring.

Next, embodiments of the electronic apparatus according to the present invention are explained.

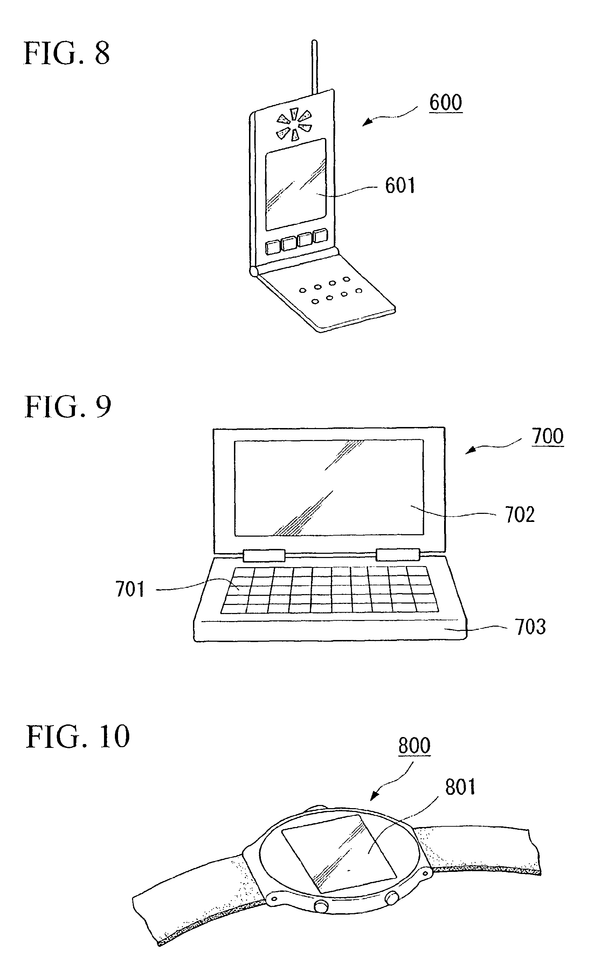

FIG. 8 is a perspective view showing an example of a mobile phone. In FIG. 8, reference numeral 600 indicates a main body of a mobile phone. Reference numeral 601 indicates a liquid crystal display section which is provided with a liquid crystal device shown in FIG. 7.

In FIG. 9, reference numeral 700 indicates an information processing device. Reference numeral 701 indicates an input section such as a keyboard. Reference numeral 703 indicates a main body of an information processing device. Reference numeral 702 indicates a liquid crystal display section which is provided with a liquid crystal device shown in FIG. 7.

FIG. 10 is a perspective view for an example of an electronic watch apparatus. In FIG. 10, reference numeral 800 indicates a main body of a watch. Reference numeral 801 indicates a liquid crystal display section which is provided with a liquid crystal device shown in FIG. 7.

Electronic apparatuses shown in FIGS. 8 to 10 are provided with a liquid crystal device according to the above embodiments; therefore, the adhesion of the wirings are strong and there hardly occurs the defect in the wirings.

Here, in the present embodiment, electronic apparatuses are provided with a liquid crystal device. However, it is possible that the present embodiment is provided with other electro-optical devices such as an organic electro-luminescent display device and a plasma display device.

Preferable embodiments according to the present invention are explained as above with reference to the attached drawings. More importantly, it should be understood that the present invention is not limited to such embodiments. In the above embodiments, factors such as a shape of each forming member and its combination are only examples. Such factors can be modified according to necessity from designing point of view within a scope of the claims.

## Claims

1. A method for forming a conductive layer wiring having a predetermined pattern on a base board (11) by disposing a first liquid above the base board (11) via a liquid ejecting section (10), the first liquid including a first metal particle, the method comprising:
preparing the base board (11), including forming an interlayer (W1) by the steps of:
controlling a surface of the base board (11) to make a contact angle of the surface against the first liquid and a second liquid between 30 degrees and 60 degrees, the second liquid being different from the first liquid and including a second metal particle different from the first metal particle; and
disposing the second liquid on the base board via the liquid ejecting section (10) to form the interlayer (W1) after the control of the surface of the base board (11); and
disposing the first liquid on the interlayer (W1) after at least a part of a dispersion medium in the second liquid disposed on the base board (11) is removed, to form the conductive layer wiring (W2) substantially on the interlayer (W1), wherein
the second metal particle includes at least one of a manganese member, a chromium member, a titanium member, a magnesium member, a silicon member, a vanadium member and an oxide of these metals, and
an adhesion force between the interlayer (W1) and the conductive layer wiring (W2) is larger than an adhesion force between the base board (11) and the conductive layer wiring (W2).

2. The method for forming a conductive layer wiring according to claim 1, wherein the interlayer (W1) is formed so as to have the same pattern as the predetermined pattern.

3. The method for forming a conductive layer wiring according to claim 2, further comprising:
converting the first liquid and the second liquid into film layers by a thermal process or an optical process.

4. The method for forming a conductive layer wiring according to claim 1, the first metal particle including at least any one of a gold particle, a silver particle, a copper particle, a palladium particle, a nickel particle and a particle of an alloy containing the above particles.

5. The method for forming a conductive layer wiring according to claim 1. a transparent conductive layer being provided on a surface of the base board (11).

6. An electro-optic device having a base board (11), the base board (11) being manufactured by the method of claim 1.

7. An electronic apparatus being provided with the electro-optic device according to claim 6.

8. The method of forming a conductive layer wiring according to claim 1, the forming of the interlayer (W1) including:
controlling the surface of the base board (11) to make the surface more liquid-repellent against the first liquid and the second liquid.

## Patentansprüche

1. Verfahren zur Bildung einer Leitungsschichtverdrahtung mit einem vorbestimmten Muster auf einer Basisplatte (11) durch Anordnen einer ersten Flüssigkeit durch einen Flüssigkeitsausstoßabschnitt (10) über der Basisplatte (11), wobei die erste Flüssigkeit ein erstes Metallpartikel enthält, wobei das Verfahren umfasst:
Vorbereiten der Basisplatte (11), einschließlich der Bildung einer Zwischenschicht (W) durch folgende Schritte:
Kontrollieren einer Oberfläche der Basisplatte (11), so dass ein Kontaktwinkel der Oberfläche gegen die erste Flüssigkeit und eine zweite Flüssigkeit zwischen 30 Grad und 60 Grad erhalten wird, wobei sich die zweite Flüssigkeit von der ersten Flüssigkeit unterscheidet und ein zweites Metallpartikel enthält, das sich vom ersten Metallpartikel unterscheidet; und
Anordnen der zweiten Flüssigkeit durch den Flüssigkeitsausstoßabschnitt (10) auf der Basisplatte zur Bildung einer Zwischenschicht (W1) nach der Kontrolle der Oberfläche der Basisplatte (11); und
Anordnen der ersten Flüssigkeit auf der Zwischenschicht (W1), nachdem zumindest ein Teil eines Dispersionsmediums in der zweiten Flüssigkeit, die auf der Basisplatte (11) angeordnet ist, entfernt ist, um die Leitungsschichtverdrahtung (W2) im Wesentlichen auf der Zwischenschicht (W1) zu bilden, wobei
das zweite Metallpartikel zumindest eines von einem Manganelement, einem Chromelement, einem Titanelement, einem Magnesiumelement, einem Siliziumelement, einem Vanadiumelement und einem Oxid dieser Metalle enthält, und
die Adhäsionskraft zwischen der Zwischenschicht (W1) und der Leitungsschichtverdrahtung (W2) größer ist als die Adhäsionskraft zwischen der Basisplatte (11) und der Leitungsschichtverdrahtung (W2).

2. Verfahren zur Bildung einer Leitungsschichtverdrahtung nach Anspruch 1, wobei die Zwischenschicht (W1) so gebildet ist, dass sie dasselbe Muster wie das vorbestimmte Muster hat.

3. Verfahren zur Bildung einer Leitungsschichtverdrahtung nach Anspruch 2, des Weiteren umfassend:
Umwandeln der ersten Flüssigkeit und der zweiten Flüssigkeit durch einen Wärmeprozess oder einen optischen Prozess in Filmschichten.

4. Verfahren zur Bildung einer Leitungsschichtverdrahtung nach Anspruch 1, wobei das erste Metallpartikel zumindest eines von einem Goldpartikel, einem Silberpartikel, einem Kupferpartikel, eine Palladiumpartikel, einem Nickelpartikel und einem Partikel einer Legierung, die die oben genannten Partikel beinhaltet, enthält.

5. Verfahren zur Bildung einer Leitungsschichtverdrahtung nach Anspruch 1, wobei eine transparente Leitungsschicht auf einer Oberfläche der Basisplatte (11) vorgesehen ist.

6. Elektro-optische Vorrichtung mit einer Basisplatte (11), wobei die Basisplatte (11) durch das Verfahren nach Anspruch 1 hergestellt wird.

7. Elektronisches Gerät, das durch die elektro-optische Vorrichtung nach Anspruch 6 bereitgestellt wird.

8. Verfahren zur Bildung einer Leitungsschichtverdrahtung nach Anspruch 1, wobei die Bildung der Zwischenschicht (W1) enthält:
Kontrollieren der Oberfläche der Basisplatte (11), um die Oberfläche gegenüber der ersten und der zweiten Flüssigkeit mehr flüssigkeitsabweisend zu machen.

## Revendications

1. Procédé pour former un câblage à couche conductrice ayant un schéma prédéterminé sur une plaque de base (11) en disposant un premier liquide au-dessus de la plaque de base (11) via une section d'éjection de liquide (10), le premier liquide comprenant une première particule métallique, le procédé comprenant :
préparation de la plaque de base (11), comprenant la formation d'une couche intermédiaire (W1) grâce aux étapes suivantes :
contrôle d'une surface de la plaque de base (11) pour faire en sorte qu'un angle de contact de la surface avec le premier liquide et un second liquide soit compris entre 30 degrés et 60 degrés, le second liquide étant différent du premier liquide et comprenant une seconde particule métallique différente de la première particule métallique; et
dépôt du second liquide sur la plaque de base via la section d'éjection de liquide (10) afin de former la couche intermédiaire (W1) après le contrôle de la surface de la plaque de base (11) ; et
dépôt du premier liquide sur la couche intermédiaire (W1) après qu'au moins une partie d'un agent de dispersion dans le second liquide disposé sur la plaque de base (11) soit enlevée, afin de former le câblage à couche conductrice (W2) sensiblement sur la couche intermédiaire (W1), dans lequel
la seconde particule métallique comprend au moins l'un parmi un élément de manganèse, un élément de chrome, un élément de titane, un élément de magnésium, un élément de silicium, un élément de vanadium, et un oxyde de ces métaux, et
une force d'adhérence entre la couche intermédiaire (W1) et le câblage à couche conductrice (W2) étant supérieure à une force d'adhérence entre la plaque de base (11) et le câblage à couche conductrice (W2).

2. Procédé pour former un câblage à couche conductrice selon la revendication 1, dans lequel la couche intermédiaire (W1) est formée de manière à avoir le même schéma que le schéma prédéterminé.

3. Procédé pour former un câblage à couche conductrice selon la revendication 2, comprenant par ailleurs :
conversion du premier liquide et du second liquide en couches en feuilles grâce à un processus thermique ou un processus optique.

4. Procédé pour former un câblage à couche conductrice selon la revendication 1, la première particule métallique comprenant au moins l'une parmi une particule d'or, une particule d'argent, une particule de cuivre, une particule de palladium, une particule de nickel et une particule en un alliage contenant les particules ci-dessus.

5. Procédé pour former un câblage à couche conductrice selon la revendication 1, une couche conductrice transparente étant fournie sur une surface de la plaque de base (11).

6. Dispositif électro-optique ayant une plaque de base (11), la plaque de base (11) étant fabriquée grâce au procédé selon la revendication 1.

7. Appareil électronique muni du dispositif électro-optique selon la revendication 6.

8. Procédé de formation d'un câblage à couche conductrice selon la revendication 1, la formation de la couche intermédiaire (W1) comprenant :
contrôle de la surface de la plaque de base (11) afin de rendre la surface plus répulsive aux liquides vis-à-vis du premier liquide et du second liquide.
